# EUROPEAN PATENT APPLICATION

(11) **EP 4 129 750 A1**
(43) Date of publication of application: **08.02.2023**
(21) Application number: 22186455.6
(22) Date of filing: 22.07.2022
(51) Int. Cl.: B60L 58/22, G01R 31/382, B60L 58/13

(54) **BATTERY MANAGEMENT DEVICE AND METHOD**

(30) Priority: 06.08.2021 JP 2021130377
(71) Applicant: TOYOTA JIDOSHA KABUSHIKI KAISHA, Toyota-shi, Aichi-ken 471-8571 (JP)
(72) Inventor: TANAKA, Hiromasa, TOYOTA-SHI, AICHI-KEN 471-8571 (JP)
(74) Representative: Cabinet Beau de Loménie

(57) **Abstract**

A battery management device (10) manages a battery (1) including a plurality of battery cells (2) in which a change in OCV relative to a change in SOC is smaller in a first SOC range than in a second SOC range. The battery management device (10) is configured to: accumulate a current flowing in each battery cell (2) to calculate the SOC of the battery cell (2); when the calculated SOC has stayed in the first SOC range for a predetermined period or more, control the cell balancing circuits (15) in such a way that the SOC of a target battery cell (2) selected from the battery cells (2) falls within the second SOC range; and calculate the SOC of the target battery cell (2) based on the relationship between the SOC and the OCV in the second SOC range and correct the SOC of each battery cell (2) by the amount of correction obtained based on the calculated SOC.

## Description

### BACKGROUND OF THE INVENTION

### 1. Field of the Invention

The present disclosure relates to a battery management device and method for managing a battery including a plurality of battery cells.

### 2. Description of Related Art

Hybrid electric vehicles (hybrid electric vehicles (HEVs) and plug-in hybrid electric vehicles (PHEVs)) are conventionally known that include: a battery including multiple battery units connected in series and an equalization circuit for reducing variation in state of charge (SOC) among the battery units by selectively discharging a battery unit with relatively high remaining capacity; and a control device for managing the battery (see, for example, Japanese Unexamined Patent Application Publication No. 2010-283922 (JP 2010-283922 A)). Each battery unit of such a hybrid electric vehicle includes one or more battery cells that are olivine iron lithium-ion secondary cells. Open circuit voltage (OCV)-SOC characteristics of such an olivine iron lithium-ion secondary cell has a first region and a second region (plateau region). In the first region, a change in OCV relative to a change in SOC is larger than a threshold. In the second region, a change in OCV relative to a change in SOC is not larger than the threshold. When an estimated value of the SOC of the battery is in the second region, the control circuit that manages the battery accumulates a current that is input and output to and from the battery and estimates the SOC. When the estimated value of the SOC of the battery has been in the second region for more than a predetermined period, the control device changes the power consumption of a motor and the power generation of a generator that is driven by an engine so that the SOC of the battery temporarily falls within the first region. The control device obtains the OCV from the battery voltage by an estimation method using an internal reaction model, and derives the SOC corresponding to the obtained OCV. This reduces an error of the estimated value of the SOC due to an error of a current sensor that detects a current, so that the estimated value can be made closer to the true value of the SOC. Even before operating the equalization circuit to equalize the SOC among the battery units, the control device also causes the SOC of the battery to temporarily fall within the first region and estimates the SOC by the estimation method using an internal reaction model.

### SUMMARY OF THE INVENTION

In such a hybrid electric vehicle including an engine and a generator, the SOC (estimated value) of a battery can be forcibly changed from the second region to the first region by changing the power consumption of a motor and the power generation of the generator that is driven by the engine. However, when the power consumption of the motor and the power generation of the generator are changed in order to change the SOC of the battery, the overall efficiency of the vehicle may be reduced. In a battery electric vehicle that does not include a generator that is driven by an engine, it is substantially impossible to forcibly change the SOC of a battery from the second region to the first region even by using the control device. Accordingly, the conventional control device has limited applicability.

The present disclosure provides a battery management device and method that improve estimation accuracy of the SOC of a battery including a plurality of battery cells in which a change in OCV relative to a change in SOC is small in a first SOC range and is large in a second SOC range, while reducing a decrease in efficiency and reducing limitation of applicability.

A battery management device according to one aspect of the present disclosure is a battery management device configured to manage a battery including a plurality of battery cells in which a change in OCV relative to a change in SOC is smaller in a first SOC range than in a second SOC range. The battery management device includes: a plurality of cell balancing circuits configured to charge, with power discharged from at least one of the battery cells, at least another one of the battery cells; an SOC calculation unit configured to accumulate a current flowing in each of the battery cells to calculate the SOC of the battery cell; a cell balancing control unit configured to, when the SOC calculated by the SOC calculation unit has stayed in the first SOC range for a predetermined period or more, control the cell balancing circuits in such a way that the SOC of a target battery cell that is one of the battery cells falls within the second SOC range; and an SOC correction unit configured to derive an SOC of the target battery cell based on a relationship between the SOC and the OCV in the second SOC range, calculate an amount of correction based on the derived SOC, and correct the SOC of each of the battery cells by the amount of correction.

The battery management device of the present disclosure manages a battery including a plurality of battery cells in which a change in OCV relative to a change in SOC is small in the first SOC range and large in the second SOC range. The battery management device includes a plurality of cell balancing circuits configured to charge, with power discharged from at least one of the battery cells, at least another one of the battery cells. The battery management device accumulates a current flowing in each of the battery cells to calculate the SOC of the battery cell. When the calculated SOC has stayed in the first SOC range for the predetermined period or more, the battery management device controls the cell balancing circuits in such a way that the SOC of a target battery cell that is one of the battery cells falls within the second SOC range. The battery management device derives the SOC of the target battery cell based on the relationship between the SOC and the OCV in the second SOC range, calculates the amount of correction based on the derived SOC, and corrects the SOC of each of the battery cells by the calculated amount of correction. Accordingly, the battery management device can change the SOC of the target battery cell to the second SOC range using the cell balancing circuits while significantly reducing electrical energy loss in the battery (battery cells). The battery management device can also accurately derive the SOC of the target battery cell based on the relationship between the SOC and the OCV in the second SOC range and properly calculate the amount of SOC correction for each of the battery cells from the SOC of the target battery cell. Moreover, a power device that consumes the power of the battery and a generator that generates electric power need not be used to change the SOC of the target battery cell to the second SOC range. This reduces a decrease in efficiency in applications of the battery management device and increases the applicable range of the battery management device. As a result, the battery management device of the present disclosure can improve estimation accuracy of the SOC of the battery including the battery cells in which a change in OCV relative to a change in SOC is small in the first SOC range and large in the second SOC range, while reducing a decrease in efficiency and reducing limitation of applicability.

In the above battery management device, the cell balancing control unit may be configured to control the cell balancing circuits so as to return the SOC of the target battery cell to a previous SOC, the previous SOC being an SOC before electrical energy is transferred between the target battery cell and the remainder of the battery cells, after the SOC correction unit derives the SOC of the target battery cell based on the relationship between the SOC and the OCV. This reduces the possibility that the SOC of the target battery cell may be determined to reach a separately set upper limit SOC or lower limit SOC after the SOC of the target battery cell is changed to the second SOC range.

In the above battery management device, the cell balancing control unit may be configured to select the battery cell as the target battery cell from the battery cells in such a way that the same battery cell is not consecutively selected as the target battery cell. This reduces degradation of a specific battery cell due to the specific battery cell being always selected as a target battery cell.

In the above battery management device, the SOC correction unit may be configured to calculate the amount of correction for each of the battery cells during charging or discharging of the target battery cell by the cell balancing circuits, based on a difference between the SOC calculated by the SOC calculation unit and the SOC obtained based on the relationship between the SOC and the OCV. The amount of correction for each of the battery cells can thus be properly calculated.

In the above battery management device, the SOC calculation unit may be configured to estimate the SOC of each of the battery cells to be lower when the SOC calculated by the SOC calculation unit has stayed in the first SOC range for a first period or more and less than the predetermined period than when the SOC calculated by the SOC calculation unit has stayed in the first SOC range for less than the first period, the first period being shorter than the predetermined period. Accordingly, a minimum SOC of the battery cells will have been apparently reduced to a certain degree immediately before the SOC of the target battery cell is changed to the second SOC range that is a lower SOC range than the first SOC range. As a result, even when the SOC of the target battery cell changed to the second SOC range is notified to the user, it will less likely to give the user a feeling that the SOC of the battery has decreased faster than expected.

In the above battery management device, the battery cell may be a lithium iron phosphate cell. The battery cells of the battery that is managed by the battery management device of the present disclosure may be battery cells other than the lithium iron phosphate cells as long as a change in OCV relative to a change in SOC is small in the first SOC range and large in the second SOC range.

In the above battery management device, the battery may be mounted on a battery electric vehicle that does not include an engine and a generator that is driven by the engine. That is, the battery management device of the present disclosure can improve estimation accuracy of the SOC of the battery without using a power device that consumes the power of the battery and a generator that generates electric power. The battery management device of the present disclosure is therefore very useful in managing a battery mounted on a battery electric vehicle.

A battery management method according to another aspect of the present disclosure is a battery management method for managing a battery including a plurality of battery cells in which a change in OCV relative to a change in SOC is smaller in a first SOC range than in a second SOC range by using a plurality of cell balancing circuits configured to charge, with power discharged from at least one of the battery cells, at least another one of the battery cells. The battery management method includes: accumulating a current flowing in each of the battery cells to calculate the SOC of the battery cell; when the SOC calculated by accumulating the current has stayed in the first SOC range for a predetermined period or more, controlling the cell balancing circuits in such a way that the SOC of a target battery cell that is one of the battery cells falls within the second SOC range; and deriving an SOC of the target battery cell based on a relationship between the SOC and the OCV in the second SOC range, calculating an amount of correction based on the derived SOC, and correcting the SOC of each of the battery cells by the amount of correction.

Such a method can improve estimation accuracy of the SOC of the battery including the battery cells in which a change in OCV relative to a change in SOC is small in the first SOC range and large in the second SOC range, while reducing a decrease in efficiency and reducing limitation of applicability.

A battery management device according to still another aspect of the present disclosure is a battery management device configured to manage a battery including a plurality of battery cells in which a change in OCV relative to a change in SOC is smaller in a first SOC range than in a second SOC range. The battery management device includes: a plurality of cell balancing circuits configured to charge, with power discharged from at least one of a plurality of battery blocks each including at least one battery cell, at least another one of the battery blocks; an SOC calculation unit configured to accumulate a current flowing in each of the battery blocks to calculate an SOC of the battery block; a cell balancing control unit configured to, when the SOC calculated by the SOC calculation unit has stayed in the first SOC range for a predetermined period or more, control the cell balancing circuits in such a way that the SOC of a target battery block that is one of the battery blocks falls within the second SOC range; and an SOC correction unit configured to derive an SOC of the target battery block based on a relationship between the SOC and the OCV in the second SOC range, calculate an amount of correction based on the derived SOC, and correct the SOC of each of the battery blocks by the amount of correction.

Such a battery management device can also improve estimation accuracy of the SOC of the battery including the battery cells in which a change in OCV relative to a change in SOC is small in the first SOC range and large in the second SOC range, while reducing a decrease in efficiency and reducing limitation of applicability.

A battery management method according to yet another aspect of the present disclosure is a battery management method for managing a battery including a plurality of battery cells in which a change in OCV relative to a change in SOC is smaller in a first SOC range than in a second SOC range by using a plurality of cell balancing circuits configured to charge, with power discharged from at least one of a plurality of battery blocks each including at least one battery cell, at least another one of the battery blocks. The battery management method includes: accumulating a current flowing in each of the battery blocks to calculate an SOC of the battery block; when the SOC calculated by accumulating the current has stayed in the first SOC range for a predetermined period or more, controlling the cell balancing circuits in such a way that the SOC of a target battery block that is one of the battery blocks falls within the second SOC range; and deriving an SOC of the target battery block based on a relationship between the SOC and the OCV in the second SOC range, calculating an amount of correction based on the derived SOC, and correcting the SOC of each of the battery blocks by the amount of correction.

Such a method can also improve estimation accuracy of the SOC of the battery including the battery cells in which a change in OCV relative to a change in SOC is small in the first SOC range and large in the second SOC range, while reducing a decrease in efficiency and reducing limitation of applicability.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a schematic configuration diagram of a vehicle equipped with a battery management device of the present disclosure;
FIG. 2 is a graph showing characteristics of battery cells of a battery that is managed by the battery management device of the present disclosure;
FIG. 3 is a schematic configuration diagram of the battery management device of the present disclosure;
FIG. 4 is a flowchart showing an example of a routine that is executed by the battery management device of the present disclosure to calculate the SOCs of a plurality of battery cells;
FIG. 5 is a flowchart showing an example of a routine that is executed by the battery management device of the present disclosure to correct the SOCs of the battery cells;
FIG. 6 illustrates a procedure of changing the SOC of a forced SOC change cell;
FIG. 7 illustrates a procedure of changing the SOC of the forced SOC change cell; and
FIG. 8 is a schematic configuration diagram of another battery management device of the present disclosure.

### DETAILED DESCRIPTION OF EMBODIMENTS

A mode for carrying out the invention of the present disclosure will be described with reference to the drawings.

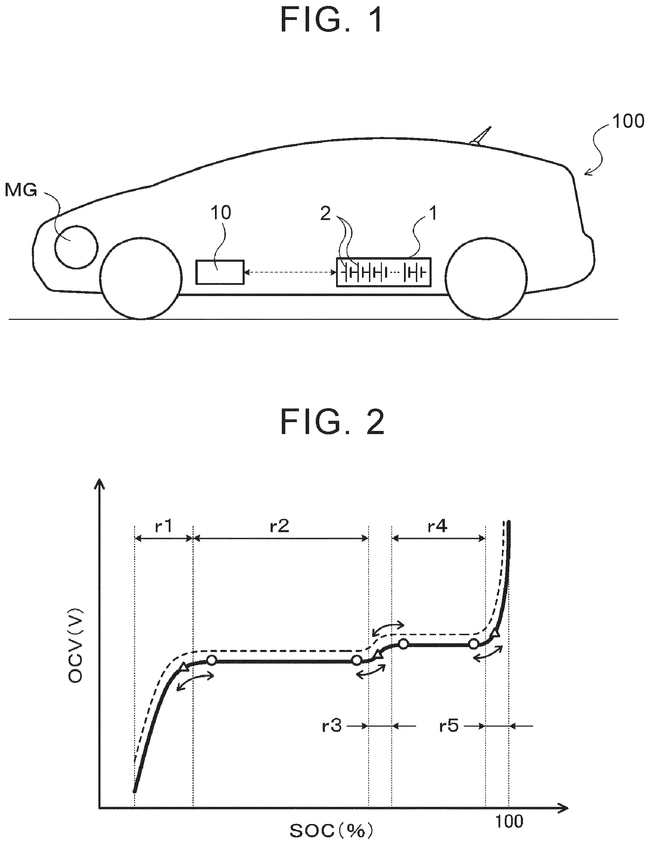

FIG. 1 is a schematic configuration diagram of a vehicle 100 equipped with a battery management device 10 of the present disclosure. The vehicle 100 shown in FIG. 1 is a battery electric vehicle (BEV) including a battery 1 and a motor generator (three-phase alternating current (AC) electric motor) MG. The battery 1 is managed by a battery management device 10, and the motor generator MG is connected to the battery 1 via a system main relay (not shown) and a power control device including an inverter etc. (not shown), and can transfer electric power with the battery 1 to output traction power and regenerative braking force. The battery 1 of the vehicle 100 can be charged with power from external charging equipment, not shown.

As shown in the figure, the battery 1 is a so-called high voltage battery including, for example, multiple battery cells 2 connected in series. The battery cells 2 may be distributed and housed in module cases of a plurality of battery modules, not shown, and the battery modules may be connected, for example, in series. The battery cells 2 in each battery module are, for example, lithium iron phosphate cells each including a positive electrode (LiFePO positive electrode) made of lithium iron phosphate having an olivine structure, namely LiFePO₄, and a negative electrode made of a graphite carbon material etc. The positive and negative electrodes of each battery cell 2 are housed inside an enclosure together with a separator and an electrolytic solution that is an organic solvent.

FIG. 2 is a graph showing the relationship between the state of charge (SOC) and the open circuit voltage (OCV) of the battery cell 2. In the graph, the continuous line represents the relationship between the SOC and the OCV during discharging of the battery cell 2, and the dashed line represents the relationship between the SOC and the OCV during charging of the battery cell 2. As shown in the graph, in the battery cell 2 having a positive electrode made of lithium iron phosphate, a change in OCV relative to a change in SOC is very small in a wide SOC range. That is, a change in OCV relative to a change in SOC is approximately zero in a range r2 and a range r4 that is a higher SOC range than the range r2 in FIG. 2. Hereinafter, the ranges r2, r4 are collectively referred to as "plateau range (first SOC range)." On the other hand, a change in OCV relative to a change in SOC is large (slope is steep) in a range r1 that is a lower SOC range than the range r2, a range r3 that is a higher SOC range than the range r2 and a lower SOC range than the range r4 (between the ranges r2 and r4), and a range r5 that is a higher SOC range than the range r4. Hereinafter, the ranges r1, r3, and r5 are collectively referred to as "non-plateau range (second SOC range)." A change in OCV relative to a change in SOC of the battery cells (2) is smaller in the first SOC range than in the second SOC range.

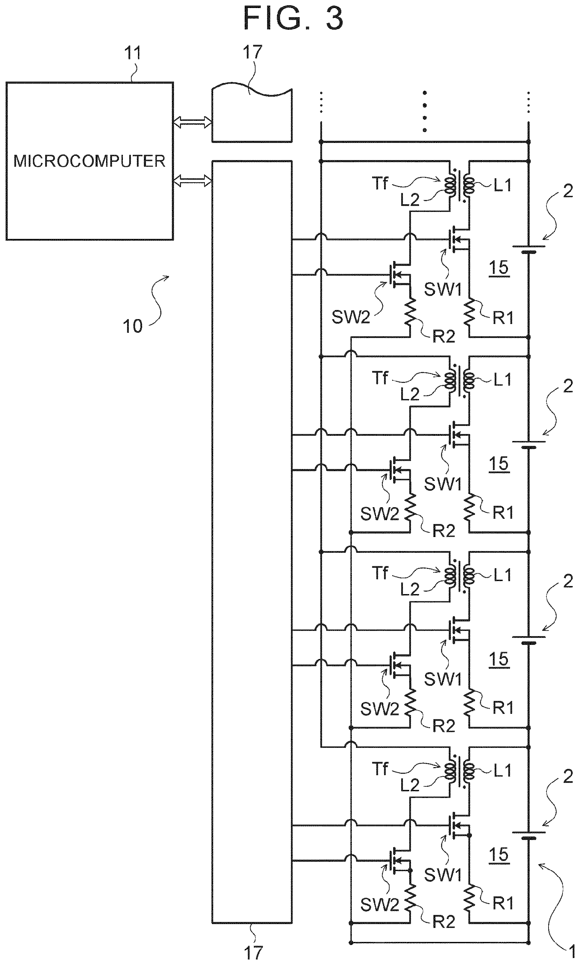

As shown in FIG. 3, the battery management device 10 of the vehicle 100 includes: a microcomputer 11 including a central processing unit (CPU), a read-only memory (ROM), and a random access memory (RAM); the same number of (plurality of) cell balancing circuits 15 as the total number of battery cells 2 in the battery 1; and a plurality of management integrated circuits (ICs) 17. Each cell balancing circuit 15 includes one flyback transformer Tf, two switching elements SW1, SW2 such as field effect transistors (FETs), and two resistors R1, R2. One cell balancing circuit 15 is connected to one battery cell 2.

As shown in FIG. 3, a primary coil L1 of each flyback transformer Tf is connected in parallel with a corresponding one of the battery cells 2 via the switching element SW1 and the resistor R1. A secondary coil L2 of each flyback transformer Tf is connected in parallel with a plurality of battery cells 2 (in the example of FIG. 3, four battery cells 2) whose SOCs (voltages) are to be equalized and which forms one group. That is, one end of the secondary coil L2 of each flyback transformer Tf is connected to one ends (e.g., positive electrodes) of the battery cells 2 via a power line. That is, the other end of the secondary coil L2 of each flyback transformer Tf is connected to the other ends (e.g., negative electrodes) of the battery cells 2 via the switching element SW2, the resistor R2, and a power line.

Accordingly, by on-off control of the switching elements SW1, SW2 of a plurality of cell balancing circuits 15 corresponding to one group, at least another one of the battery cells 2 in the group can be charged with power discharged from at least one of the battery cells 2 in the group. For example, in order to charge the remaining battery cells 2 in one group with power discharged from one of the battery cells 2 in that group, the switching element SW1 of the cell balancing circuit 15 corresponding to the one battery cell 2 is turned on. Thereafter, this switching element SW1 is turned off, and the switching elements SW2 of all the cell balancing circuits 15 in the group are turned on. The switching elements SW2 of all the cell balancing circuits 15 in the group are then turned off, and the switching elements SW1 of the cell balancing circuits 15 corresponding to the battery cells 2 other than the one battery cell 2 are turned on. These processes are then repeatedly performed.

In order to charge one of the battery cells 2 in one group with power discharged from the remaining battery cells 2 in that group, the switching elements SW1 of the cell balancing circuits 15 corresponding to the battery cells 2 other than the one battery cell 2 are turned on. Thereafter, these switching elements SW1 are turned off, and the switching elements SW2 of all the cell balancing circuits 15 in the group are turned on. The switching elements SW2 of all the cell balancing circuits 15 in the group are then turned off, and the switching element SW1 of the cell balancing circuit 15 corresponding to the one battery cell 2 is turned on. These processes are then repeatedly performed.

Each management IC 17 transfers information to and from the microcomputer 11 and controls a corresponding one(s) of the cell balancing circuits 15. In the present embodiment, one management IC 17 is provided for one group of a plurality of (four) battery cells 2 whose SOCs (voltages) are to be equalized. Each management IC 17 performs on-off control of the switching elements SW1, SW2 of the corresponding (four) cell balancing circuits 15 according to a command signal from the microcomputer 11. Each management IC 17 includes a plurality of (four) voltage sensors (not shown) that detects the voltage of the corresponding (four) battery cells 2. Each management IC 17 causes each of the corresponding voltage sensors to detect the voltage of a corresponding one of the battery cells 2 in a predetermined period, and sends the detected value of the voltage sensor to the microcomputer 11. Each management IC 17 includes a plurality of (four) current sensors (not shown) that detects a current flowing in the corresponding (four) battery cells 2. Each management IC 17 causes each of the corresponding current sensors to detect a current flowing in a corresponding one of the battery cells 2 in a predetermined period, and sends the detected value of the current sensor to the microcomputer 11.

The microcomputer 11 accumulates the current in each battery cell 2 detected by the corresponding current sensor of the management IC 17 to calculate the SOC of the battery cell 2. When predetermined execution conditions including a condition that the SOC of each battery cell 2 is within the non-plateau range, namely within the range r1, r3, or r5, are satisfied, the microcomputer 11 calculates the OCV of each battery cell 2 based on the detected value of the corresponding voltage sensor of the management IC 17, and derives the SOC of the battery cell 2 corresponding to the calculated OCV from the relationship between the SOC and the OCV in the non-plateau range (see FIG. 2). The microcomputer 11 then uses the SOC of each battery cell 2 derived based on the OCV to correct the SOC of the battery cell 2 calculated based on the current. When a predetermined execution condition for cell balancing control is satisfied, the microcomputer 11 controls the cell balancing circuits 15 in cooperation with the management IC 17 so as to equalize the SOCs (voltages) of the battery cells 2. An instrumental panel, not shown, of the vehicle 100 includes an SOC display unit that displays the SOC of the battery 1. A display control unit, not shown, of the vehicle 100 displays on the SOC display unit a minimum SOC that is a minimum value of the SOCs of the battery cells 2 calculated by the microcomputer 11 of the battery management device 10.

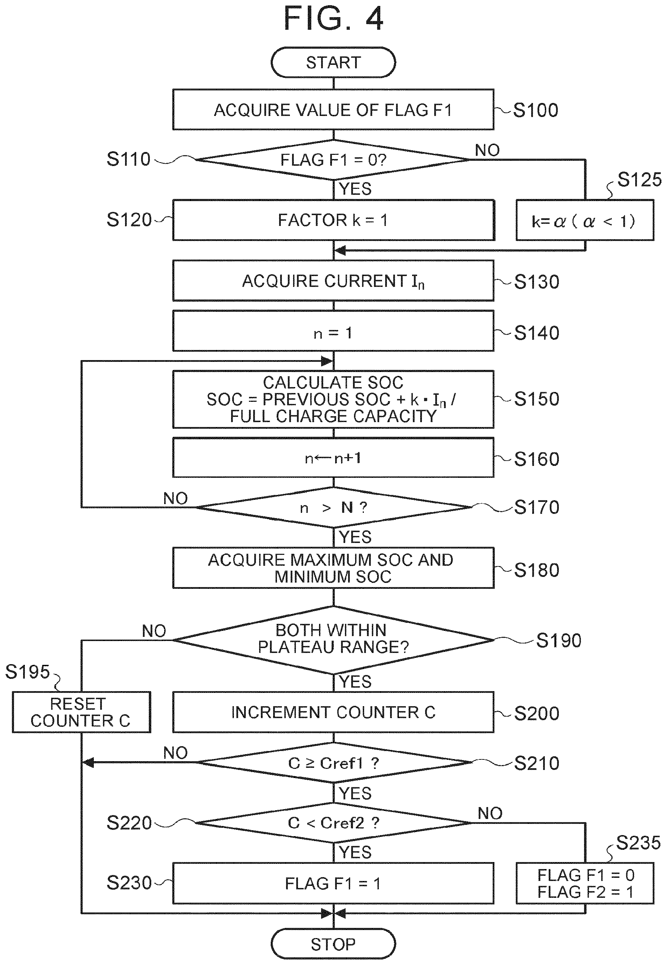

Next, a procedure of calculating the SOC of each battery cell 2 by the battery management device 10 will be described with reference to FIGS. 4 to 6 etc. FIG. 4 is a flowchart showing an example of a routine that is repeatedly executed at predetermined time intervals (very short time intervals) by the microcomputer 11 (CPU) of the battery management device 10 in order to calculate the SOC of each battery cell 2 during system startup of the vehicle 100 with a start switch (ignition (IG) switch), not shown, of the vehicle 100 turned on.

At the start of the routine of FIG. 4, the microcomputer 11 acquires the value of a flag F1 (step S100) and determines whether the value of the flag F1 is zero (step S110). When the microcomputer 11 determines that the value of the flag F1 is zero (step S110: YES), the microcomputer 11 sets a factor k to be used to calculate the SOC to "1" (step S120). On the other hand, when the microcomputer 11 determines that the value of the flag F1 is "1" (step S110: NO), the microcomputer 11 sets the factor k to be used to calculate the SOC to a predetermined positive value α that is smaller than "1" (step S125). The value α is, for example, about 0.95 to 0.99 in consideration of current sensor error (about 1 to 5%). After step S120 or S125, the microcomputer 11 acquires a current Iₙ in each of the battery cells 2 detected by the corresponding current sensor of the corresponding management IC 17 ("n" represents the number of the battery cell 2, and n = 1, 2, . . . , N-1, N, where "N" is the total number of battery cells 2) (step S130).

The microcomputer 11 then sets a variable n (number of the battery cell 2) to "1" (step S140) and calculates the SOC of the nth battery cell 2 (step S150). In step S150, the microcomputer 11 calculates the current SOC of the nth battery cell 2 by adding the product of the factor k and the current Iₙ of the nth battery cell 2 acquired in step S130 divided by the separately calculated full charge capacity of the nth battery cell 2 to the SOC (previous value) of the nth battery cell 2 calculated during the previous execution of the routine of FIG. 4. The full charge capacity of each battery cell 2 is calculated by correcting, based on temperature frequency information, the value calculated when the SOC of the battery cell 2 is within the non-plateau range. The microcomputer 11 then increments the variable n (step S160) and determines whether the variable n is larger than the total number N of battery cells 2 (step S170). When the microcomputer 11 determines that the variable n is equal to or less than the total number N of battery cells 2 (step S170: NO), step S150 and the subsequent steps are repeated.

When the microcomputer 11 calculates the SOCs of all the battery cells 2 (N battery cells 2) in step S150, the microcomputer 11 determines in step S170 that the variable n is larger than the total number N of battery cells 2. When the microcomputer 11 determines that the variable n is larger than the total number N of battery cells 2 (step S170: YES), the microcomputer 11 acquires maximum and minimum SOCs that are maximum and minimum values of the SOCs of all the battery cells 2 (step S180). The microcomputer 11 then determines whether both the maximum and minimum SOCs are within the plateau range, namely within the range r2 or r4 (step S190). When the microcomputer 11 determines that neither of the maximum and minimum SOCs is within the plateau range (step S190: NO), the microcomputer 11 resets a counter C (step S195) and ends the routine of FIG. 4. When the counter C is reset and a predetermined other execution condition is satisfied, the microcomputer 11 derives the SOC of each battery cell 2 based on the OCV corresponding to the voltage of the battery cell 2, and corrects the SOC of the battery cell 2 calculated based on the current Iₙ by using the SOC obtained based on the derived OCV.

When the microcomputer 11 determines that both the maximum and minimum SOCs are within the plateau range (step S190: YES), the microcomputer 11 increments the counter C (step S200) and determines whether the counter C is equal to or larger than a first threshold Cref1 (step S210). In the present embodiment, the first threshold Cref1 used in step S210 is determined so that the product of the first threshold Cref1 and the execution period of the routine of FIG. 4 is, for example, one week (168 hours). That is, the counter C indicates the time during which the SOC of each battery cell 2 stays in the plateau range (range r2 or r4). When the microcomputer 11 determines that the counter C is less than the first threshold Cref1 (step S210: NO), the microcomputer 11 ends the routine of FIG. 4.

On the other hand, when the microcomputer 11 determines that the counter C is equal to or larger than the first threshold Cref1 (step S210: YES), the microcomputer 11 determines whether the counter C is less than a predetermined second threshold Cref2 (step S220). In the present embodiment, the second threshold Cref2 used in step S220 is determined so that the product of the second threshold Cref2 and the execution period of the routine of FIG. 4 is, for example, one month (720 hours). When the microcomputer 11 determines that the counter C is less than the second threshold Cref2 (step S220: YES), the microcomputer 11 sets the flag F1 to "1" (step S230). The microcomputer 11 then ends the routine of FIG. 4.

When the counter C is less than the second threshold Cref2, it means that the SOC of each battery cell 2 has stayed in the plateau range (range r2 or r4) for one week or more and less than one month. In this case, by setting the flag F1 to "1" in step S230, the microcomputer 11 sets the factor k to the value α smaller than "1" in step S125 during execution of the routine of FIG. 4, so that in step S150, the SOC of each battery cell 2 is estimated to be lower than when the SOC is calculated in step S140.

When the microcomputer 11 determines that the counter C is equal to or larger than the second threshold Cref2 (step S220: NO), the microcomputer 11 sets the flag F1 to zero and sets the flag F2 to "1" (step S235). The microcomputer 11 then ends the routine of FIG. 4. When the counter C is equal to or larger than the second threshold Cref2, it means that the SOC of each battery cell 2 has stayed in the plateau range (range r2 or r4) for one month or more. That is, when the usage pattern of the vehicle 100 is, for example, such that the user repeats charging the battery 1 with external charging equipment at home and commuting to a workplace relatively close to home, the SOC of each battery cell 2 of the battery 1 may stay in the plateau range (e.g., the range r4) for one month or more. When the SOC of each battery cell 2 stays in the plateau range for a long time, a detection error of the current Iₙ in the battery cell 2 by the corresponding current sensor continues to be accumulated. This reduces calculation accuracy of the SOC of each battery cell 2, so that the SOC of the battery 1 displayed on the SOC display unit of the vehicle 100 deviates from the minimum SOC of the battery cells 2.

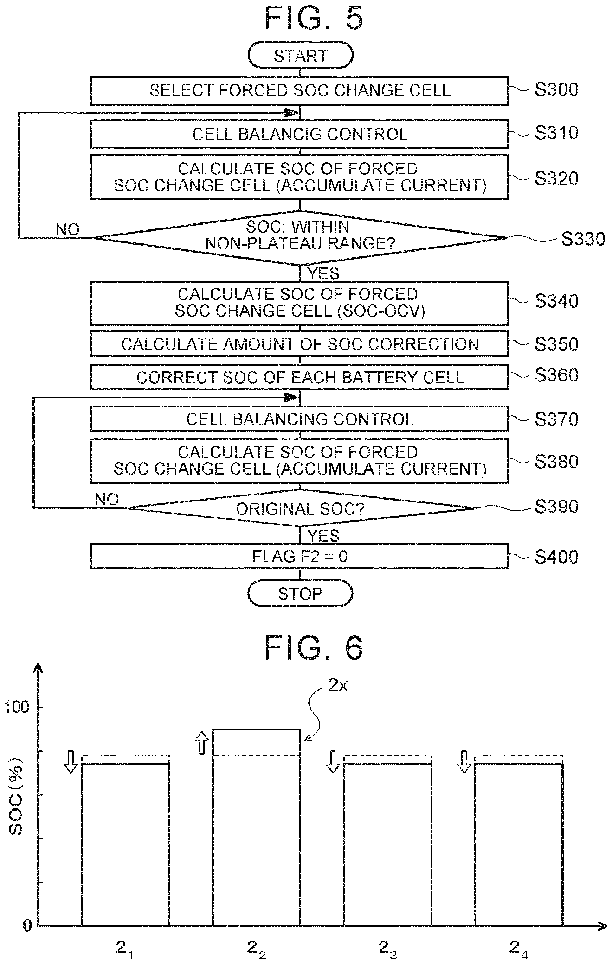

In consideration of this, the microcomputer 11 of the battery management device 10 sets the flag F2 to "1" in step S235 and ends the routine of FIG. 4, and then executes a routine of FIG. 5 in order to correct the SOCs of the battery cells 2. At the start of the routine of FIG. 5, the microcomputer 11 selects one of the battery cells 2 as a forced SOC change cell 2x (target battery cell, see FIG. 6) (step S300). The forced SOC change cell 2x is a battery cell 2 whose SOC is to be forcibly changed from the plateau range to the non-plateau range, and is basically a battery cell 2 whose SOC (see circles in FIG. 2) is closest to the maximum or minimum SOC in the non-plateau range next to the plateau range including the SOCs of the battery cells 2.

When a battery cell 2 whose SOC is closest to the maximum or minimum value of the SOC in this non-plateau range was selected as a forced SOC change cell 2x in step S300 during the previous execution of the routine of FIG. 5, this battery cell 2 will not be selected as a forced SOC change cell 2x in step S300 during the current execution of the routine of FIG. 5. In this case, a battery cell 2 whose SOC is the second closest to the maximum or minimum value of the SOC in the non-plateau range is selected as a forced SOC change cell 2x. That is, the same battery cell 2 will not be consecutively selected as a forced SOC change cell 2x in step S300.

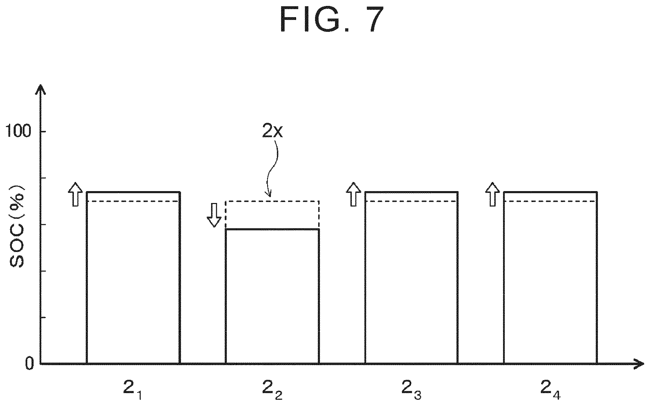

After step S300, the microcomputer 11 controls, in cooperation with the management IC 17, the switching elements SW1, SW2 of the cell balancing circuits 15 corresponding to the group including the forced SOC change cell 2x so that the SOC of the forced SOC change cell 2x falls within this non-plateau range (see triangle in FIG. 2) (step S310). For example, as shown in FIG. 6, when the battery cell 2₂ is selected as a forced SOC change cell 2x from the battery cells 2₁, 2₂, 2₃, and 2₄ that form one group and the SOC of the battery cell 2₂ is to be changed from the range r4 to the range r5 that is a higher SOC range than the range r4, the switching elements SW1, SW2 of the cell balancing circuits 15 are controlled so that the battery cell 2₂ that is a forced SOC change cell 2x is charged with power discharged from the battery cells 2₁, 2₃, and 2₄ other than the battery cell 2₂. For example, as shown in FIG. 7, when the battery cell 2₂ is selected as a forced SOC change cell 2x from the battery cells 2₁, 2₂, 2₃, and 2₄ that form one group and the SOC of the battery cell 2₂ is to be changed from the range r4 to the range r3 that is a lower SOC range than the range r4, the switching elements SW1, SW2 of the cell balancing circuits 15 are controlled so that the battery cells 2₁, 2₃, and 2₄ other than the battery cell 2₂ that is a forced SOC change cell 2x are charged with power discharged from the battery cell 2₂.

During step S310, the microcomputer 11 accumulates a current flowing in the forced SOC change cell 2x to calculate the SOC of the forced SOC change cell 2x (step S320) as in step S150 of FIG. 4. The microcomputer 11 then determines whether the SOC calculated in step S320 is within the non-plateau range (step S330). When the microcomputer 11 determines that the SOC calculated in step S320 is not within the non-plateau range (step S330: NO), the microcomputer 11 repeats step S310 to S330.

When the microcomputer 11 determines that the SOC calculated in step S320 is within the non-plateau range (step S330: YES), the microcomputer 11 calculates the OCV based on the voltage of the forced SOC change cell 2x detected by the voltage sensor of the management IC 17, and derives the SOC of the forced SOC change cell 2x corresponding to the calculated OCV from a map, not shown, created based on the relationship between the SOC and the OCV (see FIG. 2) (step S340). The microcomputer 11 then calculates the amount of SOC correction for each battery cell 2, based on the SOC of the forced SOC change cell 2x calculated in step S320 immediately before step S340 and the SOC of the forced SOC change cell 2x derived in step S340 (step S350). In step S350, the microcomputer 11 calculates the amount of SOC correction for each battery cell 2 by multiplying the difference between the SOC calculated in step S320 and the SOC derived in step S340 by a factor that is based on the ratio between the full charge capacity of the forced SOC change cell 2x and the full charge capacity of each battery cell 2. The microcomputer 11 then corrects the SOC of each battery cell 2 calculated in step S150 of FIG. 4 immediately before executing the routine of FIG. 5 by the amount of SOC correction calculated in step S350 (step S360).

After step S360, the microcomputer 11 controls, in cooperation with the management IC 17, the switching elements SW1, SW2 of the cell balancing circuits 15 corresponding to the group including the forced SOC change cell 2x so as to return the SOC of the forced SOC change cell 2x to a previous SOC, the previous SOC being an SOC before the electrical energy is transferred between the forced SOC change cell 2x and the other battery cells 2 in the group (step S370). During step S370, the microcomputer 11 accumulates a current flowing in the forced SOC change cell 2x to calculate the SOC of the forced SOC change cell 2x (step S380) as in step S150 of FIG. 4.

The microcomputer 11 then determine whether the SOC of the forced SOC change cell 2x calculated in step S380 is approximately equal to the SOC of the forced SOC change cell 2x before the forced change calculated in step S150 of FIG. 4 immediately before executing the routine of FIG. 5 (step S390). When the microcomputer 11 determines that the SOC of the forced SOC change cell 2x calculated in step S380 is not approximately equal to the SOC before the forced change (step S390: NO), the microcomputer 11 repeats steps S370 to S390. When the microcomputer 11 determines that the SOC of the forced SOC change cell 2x calculated in step S380 is approximately equal to the SOC before the forced change (step S390: YES), the microcomputer 11 sets the flag F2 to zero (step S400) and ends the routine of FIG. 5.

As described above, the battery management device 10 of the vehicle 100 manages the battery 1 including the battery cells 2 in which a change in OCV relative to a change in SOC is small in the plateau range (first SOC range) and large in the non-plateau range (second SOC range). The battery management device 10 includes the cell balancing circuits 15, and the cell balancing circuits 15 can charge, with power discharged from at least one of the battery cells 2 in a corresponding group, at least another one of the battery cells 2 in the group.

The microcomputer 11 that is an SOC calculation unit accumulates the current Iₙ flowing in each battery cell 2 to calculate the SOC of the battery cell 2 (step S150 of FIG. 4). When the calculated SOC has stayed in the plateau range (first SOC range) for, for example, one month (predetermined period) or more, the microcomputer 11 that is a cell balancing control unit controls the corresponding cell balancing circuits 15 so that the SOC of the forced SOC change cell 2x (target battery cell) that is one of the battery cells 2 falls within the non-plateau range (second SOC range) (steps S310 to S330 of FIG. 5). The microcomputer 11 that is an SOC correction unit derives the SOC of the forced SOC change cell 2x based on the relationship between the SOC and the OCV in the non-plateau range, calculates the amount of SOC correction based on the derived SOC, and corrects the SOC of each battery cell 2 by the amount of SOC correction (steps S340 to S360 of FIG. 5).

Accordingly, the battery management device 10 can change the SOC of the forced SOC change cell 2x to the non-plateau range using the cell balancing circuits 15 while significantly reducing electrical energy loss in the battery 1 (battery cells 2). The battery management device 10 can also accurately derive the SOC of the forced SOC change cell 2x based on the relationship between the SOC and the OCV in the non-plateau range and properly calculate the amount of SOC correction for each battery cell 2 from the SOC of the forced SOC change cell 2x. Moreover, a power device that consumes the power of the battery 1 such as motor generator MG and a generator that generates electric power need not be used to change the SOC of the forced SOC change cell 2x to the non-plateau range. This reduces a decrease in efficiency in applications of the battery management device 10, and increases the applicable range of the battery management device 10 to, for example, battery electric vehicles (BEVs) that do not include a generator. As a result, the battery management device 10 can improve estimation accuracy of the SOC of the battery 1 including the battery cells 2 in which a change in OCV relative to a change in SOC is small in the plateau range and is large in the non-plateau range, while reducing a decrease in efficiency of the vehicle 100 that does not include a generator that is driven by an engine.

In the above embodiment, the microcomputer 11 that is a cell balancing control unit derives the SOC based on the relationship between the SOC and the OCV in the non-plateau range in step S340, and then controls the corresponding cell balancing circuits 15 so as to return the SOC of the forced SOC change cell 2x to a previous SOC, the previous SOC being an SOC before the electrical energy is transferred between the forced SOC change cell 2x and the other battery cells 2 (steps S370 to S390 of FIG. 5). This reduces the possibility that the SOC of the forced SOC change cell 2x may be determined to reach a separately set upper limit SOC or lower limit SOC after the SOC of the forced SOC change cell 2x is changed to the non-plateau range.

The microcomputer 11 that is a cell balancing control unit selects a battery cell 2 as a forced SOC change cell 2x from the battery cells 2 according to a predetermined limitation (for example, in order of closeness to the maximum or minimum value of the SOC in the non-plateau range) so that the same battery cell 2 will not be consecutively selected as a forced SOC change cell 2x (step S300 of FIG. 5). This reduces degradation of a specific battery cell 2 due to the specific battery cell 2 being always selected as a forced SOC change cell 2x. When the battery cells 2 include a plurality of replaced battery cells, a forced SOC change cell 2x may be selected only from the replaced battery cells in step S300 of FIG. 5. In step S300 of FIG. 5, a battery cell 2 that is frequently exposed to high temperatures, namely a battery cell 2 whose degradation may have been accelerated, may be excluded from being selected as a forced SOC change cell 2x, based on the temperature frequency information of the battery cells 2.

In the above embodiment, the microcomputer 11 that is an SOC correction unit calculates the amount of SOC correction for each battery cell 2 during charging or discharging of the forced SOC change cell 2x by the cell balancing circuits 15, based on the full charge capacity of each battery cell 2 and the difference between the SOC calculated in step S320 and the SOC derived in step S340 based on the relationship between the SOC and the OCV (step S350 of FIG. 5). The amount of SOC correction for each battery cell 2 can thus be properly calculated.

The microcomputer 11 that is an SOC calculation unit estimates the SOC of each battery cell 2 to be lower when the SOC of the battery cell 2 has stayed in the plateau range (range r2 or r4) for a first period or more and less than the predetermined period, namely for one week (first period) or more and less than one month (predetermined period), than when the SOC of the battery cell 2 has stayed in the plateau range (range r2 or r4) for less than one week (steps S125 and S130 to S170 of FIG. 4). Accordingly, the minimum SOC of the battery cells 2 will have been apparently reduced to a certain degree immediately before the SOC of the forced SOC change cell 2x is changed to the non-plateau range (range r1 or r3) that is a lower SOC range than the plateau range (range r2 or r4). As a result, even when the SOC of the forced SOC change cell 2x changed to the non-plateau range is notified to the user via the SOC display unit, it will less likely to give the user a feeling that the SOC of the battery 1 has decreased faster than expected. Moreover, since the SOC of each battery cell 2 is estimated to be lower when the SOC of the battery cell 2 has stayed in the plateau range (range r2 or r4) for one week or more and less than one month, the SOC calculated in step S150 of FIG. 4 is made closer to the non-plateau range (range r1 or r3), so that an increase in change in SOC of the forced SOC change cell 2x in the process of FIG. 5 can be reduced.

The battery management device 10 is mounted on the vehicle 100, namely a battery electric vehicle that does not include an engine and a generator that is driven by the engine, and can improve estimation accuracy of the SOC of the battery 1 without using a power device that consumes the power of the battery 1 such as motor generator MG and a generator that generates electric power. Accordingly, the battery management device 10 is very useful in managing the battery 1 mounted on the vehicle 100 that is a battery electric vehicle. It should be understood that the battery 1 and the battery management device 10 can also be mounted on hybrid electric vehicles (HEVs, PHEVs) including an engine and a generator that is driven by the engine.

In the above embodiment, the battery cells 2 of the battery 1 are lithium iron phosphate cells. However, the present disclosure is not limited to this. That is, the battery cells 2 of the battery 1 that is managed by the battery management device 10 may be battery cells other than the lithium iron phosphate cells as long as a change in OCV relative to a change in SOC is small in the plateau range and large in the non-plateau range.

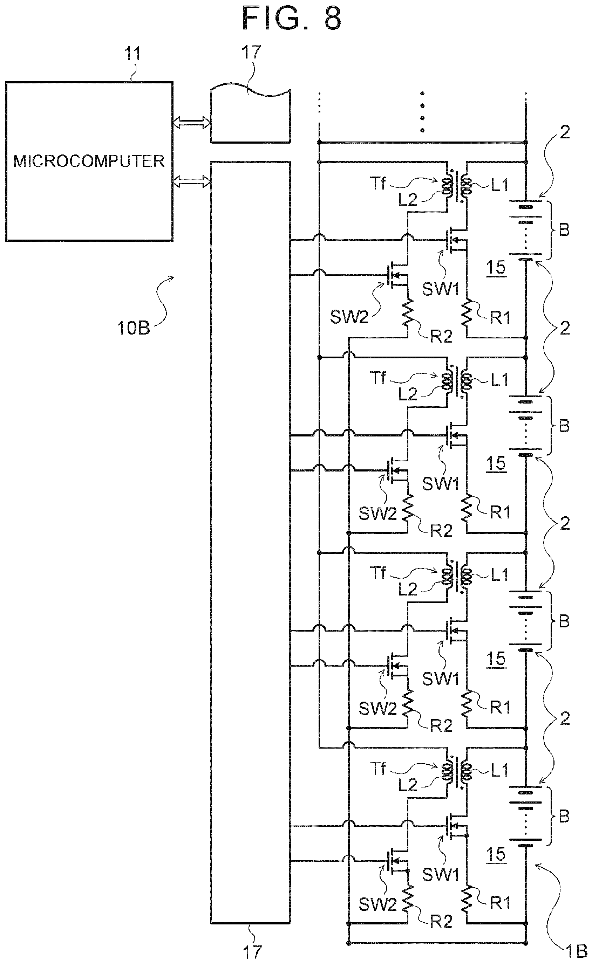

In the battery management device 10, one cell balancing circuit 15 is provided for one battery cell 2. However, the present disclosure is not limited to this. In a battery management device 10B shown in FIG. 8, one cell balancing circuit 15 is provided for each of multiple battery blocks B each including a plurality of battery cells 2. That is, the battery management device 10B includes the same number of (plurality of) cell balancing circuits 15 as the total number of battery blocks B that is smaller than the total number of battery cells 2. The battery management device 10B thus includes a smaller number of cell balancing circuits 15 and thus reduces an increase in cost. By on-off control of the switching elements SW1, SW2 of, for example, four cell balancing circuits 15 corresponding to one group of four battery blocks B, the battery management device 10B can charge, with power discharged from at least one (battery cells 2) of the battery blocks B in the group, at least another one (battery cells 2) of the battery blocks B in the group.

In the battery management device 10B of FIG. 8, the microcomputer 11 that is an SOC calculation unit calculates the SOC of each battery block B by accumulating a current in the battery block B detected by the current sensor, not shown, of the management IC 17. When, for example, the maximum and minimum SOCs of the battery blocks B has stayed in the plateau range for the predetermined period (e.g., one month) or more, the microcomputer 11 that is a cell balancing unit controls the switching elements SW1, SW2 of the corresponding cell balancing circuits 15 so that the SOC of a forced SOC change battery block (target battery block) that is one of the battery blocks B falls within the non-plateau range. Moreover, the microcomputer 11 that is an SOC correction unit derives the SOC of the forced SOC change battery block based on the relationship between the SOC and the OCV in the non-plateau range, calculates the amount of SOC correction based on the derived SOC, and corrects the SOC of each battery block B by the calculated amount of SOC correction. This can also improve estimation accuracy of the SOC of a battery 1B including the battery cells 2 while reducing a decrease in efficiency in applications of the battery management device 10B and reducing limitation of applicability.

In the battery management devices 10, 10B, the configuration of the cell balancing circuit 15 is not limited to the configurations shown in FIGS. 3 and 8. That is, the cell balancing circuit 15 may include a bidirectional direct current to direct current (DC-to-DC) converter.

It should be understood that the invention of the present disclosure is not limited to the above embodiment, and that various modifications can be made within the scope of the present disclosure. The above embodiment is merely a specific form of the invention described in the "SUMMARY OF THE INVENTION" section, and is not intended to limit the elements of the invention described in the "SUMMARY OF THE INVENTION" section.

The invention of the present disclosure is applicable in, for example, the manufacturing field of battery management devices that manage a battery including a plurality of battery cells.

## Claims

1. A battery management device (10) configured to manage a battery (1) including a plurality of battery cells (2) in which a change in OCV relative to a change in SOC is smaller in a first SOC range than in a second SOC range, the battery management device (10) comprising:
a plurality of cell balancing circuits (15) configured to charge, with power discharged from at least one of the battery cells (2), at least another one of the battery cells (2);
an SOC calculation unit configured to accumulate a current flowing in each of the battery cells (2) to calculate the SOC of the battery cell (2);
a cell balancing control unit configured to, when the SOC calculated by the SOC calculation unit has stayed in the first SOC range for a predetermined period or more, control the cell balancing circuits (15) in such a way that the SOC of a target battery cell (2) that is one of the battery cells (2) falls within the second SOC range; and
an SOC correction unit configured to derive the SOC of the target battery cell (2) based on a relationship between the SOC and the OCV in the second SOC range, calculate an amount of correction based on the derived SOC, and correct the SOC of each of the battery cells (2) by the amount of correction.

2. The battery management device (10) according to claim 1, wherein the cell balancing control unit is configured to control the cell balancing circuits (15) so as to return the SOC of the target battery cell (2) to a previous SOC, the previous SOC being an SOC before electrical energy is transferred between the target battery cell (2) and the remainder of the battery cells (2), after the SOC correction unit derives the SOC of the target battery cell (2) based on the relationship between the SOC and the OCV.

3. The battery management device (10) according to claim 1 or 2, wherein the cell balancing control unit is configured to select the battery cell (2) as the target battery cell (2) from the battery cells (2) in such a way that the same battery cell (2) is not consecutively selected as the target battery cell (2).

4. The battery management device (10) according to any one of claims 1 to 3, wherein the SOC correction unit is configured to calculate the amount of correction for each of the battery cells (2) during charging or discharging of the target battery cell (2) by the cell balancing circuits (15), based on a difference between the SOC calculated by the SOC calculation unit and the SOC obtained based on the relationship between the SOC and the OCV.

5. The battery management device (10) according to any one of claims 1 to 4, wherein the SOC calculation unit is configured to estimate the SOC of each of the battery cells (2) to be lower when the SOC calculated by the SOC calculation unit has stayed in the first SOC range for a first period or more and less than the predetermined period than when the SOC calculated by the SOC calculation unit has stayed in the first SOC range for less than the first period, the first period being shorter than the predetermined period.

6. The battery management device (10) according to any one of claims 1 to 5, wherein the battery cell (2) is a lithium iron phosphate cell.

7. The battery management device (10) according to any one of claims 1 to 6, wherein the battery (1) is mounted on a battery electric vehicle that does not include an engine and a generator that is driven by the engine.

8. A battery management method for managing a battery (1) including a plurality of battery cells (2) in which a change in OCV relative to a change in SOC is smaller in a first SOC range than in a second SOC range by using a plurality of cell balancing circuits (15) configured to charge, with power discharged from at least one of the battery cells (2), at least another one of the battery cells (2), the battery management method comprising:
accumulating a current flowing in each of the battery cells (2) to calculate the SOC of the battery cell (2);
when the SOC calculated by accumulating the current has stayed in the first SOC range for a predetermined period or more, controlling the cell balancing circuits (15) in such a way that the SOC of a target battery cell (2) that is one of the battery cells (2) falls within the second SOC range; and
deriving the SOC of the target battery cell (2) based on a relationship between the SOC and the OCV in the second SOC range, calculating an amount of correction based on the derived SOC, and correcting the SOC of each of the battery cells (2) by the amount of correction.

9. A battery management device (10B) configured to manage a battery (1B) including a plurality of battery cells (2) in which a change in OCV relative to a change in SOC is smaller in a first SOC range than in a second SOC range, the battery management device (10B) comprising:
a plurality of cell balancing circuits (15) configured to charge, with power discharged from at least one of a plurality of battery blocks (B) each including at least one battery cell (2), at least another one of the battery blocks (B);
an SOC calculation unit configured to accumulate a current flowing in each of the battery blocks (B) to calculate an SOC of the battery block (B);
a cell balancing control unit configured to, when the SOC calculated by the SOC calculation unit has stayed in the first SOC range for a predetermined period or more, control the cell balancing circuits (15) in such a way that the SOC of a target battery block (B) that is one of the battery blocks (B) falls within the second SOC range; and
an SOC correction unit configured to derive the SOC of the target battery block (B) based on a relationship between the SOC and the OCV in the second SOC range, calculate an amount of correction based on the derived SOC, and correct the SOC of each of the battery blocks (B) by the amount of correction.

10. A battery management method for managing a battery (1B) including a plurality of battery cells (2) in which a change in OCV relative to a change in SOC is smaller in a first SOC range than in a second SOC range by using a plurality of cell balancing circuits (15) configured to charge, with power discharged from at least one of a plurality of battery blocks (B) each including at least one battery cell (2), at least another one of the battery blocks (B), the battery management method comprising:
accumulating a current flowing in each of the battery blocks (B) to calculate an SOC of the battery block (B);
when the SOC calculated by accumulating the current has stayed in the first SOC range for a predetermined period or more, controlling the cell balancing circuits (15) in such a way that the SOC of a target battery block (B) that is one of the battery blocks (B) falls within the second SOC range; and
deriving the SOC of the target battery block (B) based on a relationship between the SOC and the OCV in the second SOC range, calculating an amount of correction based on the derived SOC, and correcting the SOC of each of the battery blocks (B) by the amount of correction.
